# EUROPÄISCHE PATENTSCHRIFT

(11) **EP 0 594 074 B1**
(45) Veröffentlichungstag und Bekanntmachung des Hinweises auf die Patenterteilung: **17.12.1997**
(21) Anmeldenummer: 93116683.9
(22) Anmeldetag: 15.10.1993
(51) Int. Cl.: H03H 11/46, H03H 11/24, H03G 1/00

(54) **Stellbarer elektronischer Widerstand**
Controllable electronic resistance
Résistance électronique contrôlable

(30) Priorität: 22.10.1992 DE 4235584
(43) Veröffentlichungstag der Anmeldung: 27.04.1994
(73) Patentinhaber: NOKIA TECHNOLOGY GmbH, 75175 Pforzheim (DE)
(72) Erfinder: Reime, Gerd, D-75328 Schömberg 4 (DE); Richter, Andres, D-75181 Pforzheim (DE)

(56) Entgegenhaltungen:
- DE-A- 2 900 911
- DE-A- 2 950 584
- DE-A- 3 021 788
- DE-A- 4 129 334

## Beschreibung

Die Erfindung betrifft einen stellbaren elektronischen Widerstand gemäß dem Oberbegriff des Anspruches 1.

Solch eine Anordnung ist z.B. aus DE-A-3 021 788 bekannt.

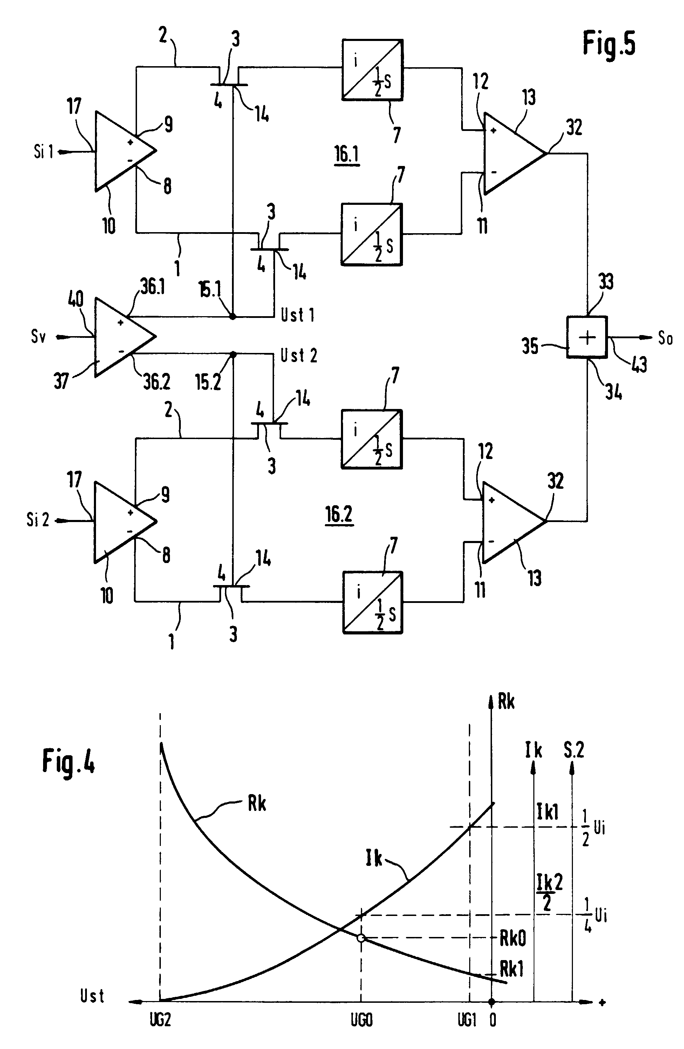

Häufig besteht der Wunsch, einen stellbaren Widerstand, einen Spannungsteiler oder ein Potentiometer elektronisch nachzubilden, d. h. mit Halbleitern nachzubilden, um damit auf mechanische Bauelemente verzichten zu können. Besonders geeignet sind hierzu Feldeffekttransistoren, die sich bei kleinen Drain-Source-Spannungen näherungsweise wie ohmsche Widerstände verhalten, deren Größe sich mit Hilfe der Gate-Source-Spannung in weiten Grenzen verändern läßt. Ein derartiger stellbarer elektronischer Widerstand mit einen Feldeffekttransistor ist beispielsweise auf den Seiten 91 und 92 des Lehrbuches "Halbleiter-Schaltungstechnik" von U. Tietze - Ch. Schenk, Springer-Verlag Berlin 1980 beschrieben. Der dort in Abb. 5.20 und zugehörigem Text beschriebene steuerbare Spannungsteiler enthält im Signalweg einen ohmschen Widerstand und im Ableitweg die Drain-Source-Strecke eines Feldeffekttransistors. Um die Nichtlinearität des Kanalwiderstandes der Drain-Source-Strecke des Feldeffekttransistors zu kompensieren, ist zwischen den Abgriffspunkt des Spannungsteilers und die Steuerelektrode des Feldeffekttransistors ein Entzerrerwiderstand geschaltet. Über diesen Widerstand entsteht jedoch eine direkte elektrische Verbindung vom Steuerkreis in den Arbeitskreis des stellbaren elektronischen Widerstandes, die nicht immer erwünscht ist. Diese Rückkopplung erhöht zwar die Linearität des Aussteuerbereiches auf etwa ± 1 Volt, kann jedoch durch kapazitive Einflüsse die Übertragungsgrenzfrequenz erheblich beschränken. In vielen Fällen wird außerdem bei einem weiten Stellbereich zusätzlich ein größerer Ausssteuerbereich gefordert, den die bekannte Schaltung nicht mehr erfüllen kann. Andererseits wird oftmals der stellbare Widerstand direkt im Längszweig eines Signalwegs benötigt.

Der Erfindung liegt die Aufgabe zugrunde, einen stellbaren elektronischen Widerstand der eingangs genannten Art derart auszubilden, daß er unmittelbar im Längszweig eines Signalweges angeordnet werden kann, daß der ohmsche Widerstand in einem weiten Stellbereich variierbar ist und daß größere Signalamplituden als mit den bekannten Lösungen mit geringer Verzerrung übertragen werden können. Diese Aufgabe wird gemäß dem Text des Anspruches 1 durch die darin angegebenen Merkmale vorteilhaft gelöst.

Durch die Aufteilung des stellbaren elektronischen Widerstandes in zwei parallele Signalwege, denen gegenphasige Signale zugeführt werden und die am Ausgang wieder zu einem Signalweg zusammengeführt werden, mit je einem Ladungsträgerkanal, deren Widerstandskennlinie der Anwendung entsprechend ausgewählt ist, wird eine hohe Linearität der Widerstandskennlinie, die aus beiden Signalwegen resultiert, erzielt und über einen weiten Stellbereich das Übertragen von Signalen mit großen Signalamplituden ohne Verzerrungen ermöglicht.

Die Stufe, die jeweils der Ausgangselektrode des Ladungsträgerkanals folgt, weist einen geringen Eingangswiderstand auf, der gegenüber dem niedrigsten einstellbaren Widerstand des Ladungsträgerkanals so gering ist, daß an ihm keine Rückkopplung auftritt, die die Stellspannung beeinflußt. Diese Stufe wandelt den im Ladungsträgerkanal fließenden Signalstrom in eine Signalspannung mit einer dem Stromwert entsprechenden Größe zurück.

Ein erfindungsgemäßer stellbarer elektronischer Widerstand der angegebenen Art kann ohne weiteres als Teil einer integrierten Schaltung hergestellt werden.

Als besonders vorteilhaft wird es angesehen, als Ladungsträgerkanal den Drain-Source-Kanal eines Feldeffekttransistors zu verwenden. In Folge der besonders vorteilhaften Kennlinienkompensation gemäß der Erfindung kann jedoch auch der steuerbare Ladungsträgerkanal anderer Halbleiterbauelemente, beispielsweise von bipolaren Transistoren als stellbarer Widerstand verwendet werden.

In einer besonderen Ausbildung wird zum Erzeugen der gegenphasige Signale ein Verstärker mit Gegentaktausgängen verwendet. Dem entsprechend sind in einer vorteilhaften Ausbildung an die Ausgänge der beiden Signalwege die Eingänge einer Schaltung angeschlossen, die eine Signaldifferenz bildet und dadurch gleichzeitig das Zusammenführen der beiden Signalwege am Ausgang vornimmt. Eine andere vorteilhafte Erzeugung von gegenphasigen Signalen wird mittels Invertern durchgeführt, von denen ein Phaseninverter im einen Signalweg vor dem Eingang des Ladungsträgerkanales und ein Phaseninverter im anderen Signalweg hinter dem Ausgang des Strom-Spannungswandlers angeordnet ist.

In einer weiteren Ausgestaltung der Erfindung sind den Steuerelektroden der Halbleiterbauelemente Anpaßschaltungen vorgeschaltet zum Abgleichen des Kanalwiderstandes der Ladungsträgerkanäle auf ein am Stelleingang des elektronischen Widerstandes anliegendes Stellsignal.

Der erfindungsgemäße elektronische Widerstandes kann auch vorteilhaft als schneller Schalter im Übertragungsweg eines zu übertragenden Signals, beispielsweise eines Videosignals verwendet werden. Durch das Zusammenführen der gegenphasigen Signale am Ausgang der ansonsten pegel- und laufzeitgleichen Signalwege werden die in diese beiden Signalwege entstandenen Verzerrungen nahezu vollständig beseitigt. Der Schaltvorgang erfolgt in diesem Fall durch einen ersten Schaltpegel eines Schaltsignales, der den minimalen Kanalwiderstand jedes Ladungsträgerkanals einstellt und durch einen zweiten Schaltpegel des Schaltsignales, der so bemessen ist, daß er jeden Ladungsträgerkanal gerade sperrt.

Ein derartiger elektronischer Schalter weist unter anderem den Vorteil auf, daß der Schaltvorgang dem Verlauf einer endlich steilen Schaltflanke oder sogar einer speziellen Schaltkurve folgt. Vorteilhaft ist auch, daß langsame Schaltvorgänge mit Stellsignalwerten, die innerhalb des Bereiches der beiden Schaltpegel verlaufen, entsprechend dem Verlauf des Stellsignals ausgeführt werden.

Die Erfindung wird nachfolgend anhand vorteilhafter Ausführungsbeispiele näher erläutert. In den dazugehörigen Zeichnungen zeigen
- Fig. 1: eine Blockschaltung eines stellbaren elektronischen Widerstandes mit einem eingangsseitigen Verstärker mit Gegentaktausgängen und einem ausgangsseitigen Differenzverstärker,
- Fig. 2: ein Pfeilediagramm der augenblicklichen Signalpegel und Signalrichtungen an den in Fig. 1 gekennzeichneten Stellen,
- Fig. 3: ein weiteres Blockschaltbild eines stellbaren elektronischen Widerstandes mit einem Phaseninverter in jedem Signalweg,
- Fig. 4: ein Diagramm des Verlaufes des Kanalwiderstandes vom Ladungsträgerkanal und vom Kanalstrom in Abhängigkeit von der Stellspannung an den in die Signalwege geschalteten Halbleiterbauelemente,
- Fig. 5: ein Blockschaltbild einer Signalüberblendschaltung mit zwei stellbaren elektronischen Widerständen,
- Fig. 6 und Fig. 7: je die Diagramme a), b) und c) des Kurvenverlaufes der eingangs- und ausgangsseitigen Stellsignale an der Stellsignalschaltung für eine in Fig. 5 dargestellte Überblendschaltung und je ein Diagramm d) des Überblendverhältnisses der übertragenen Signale.

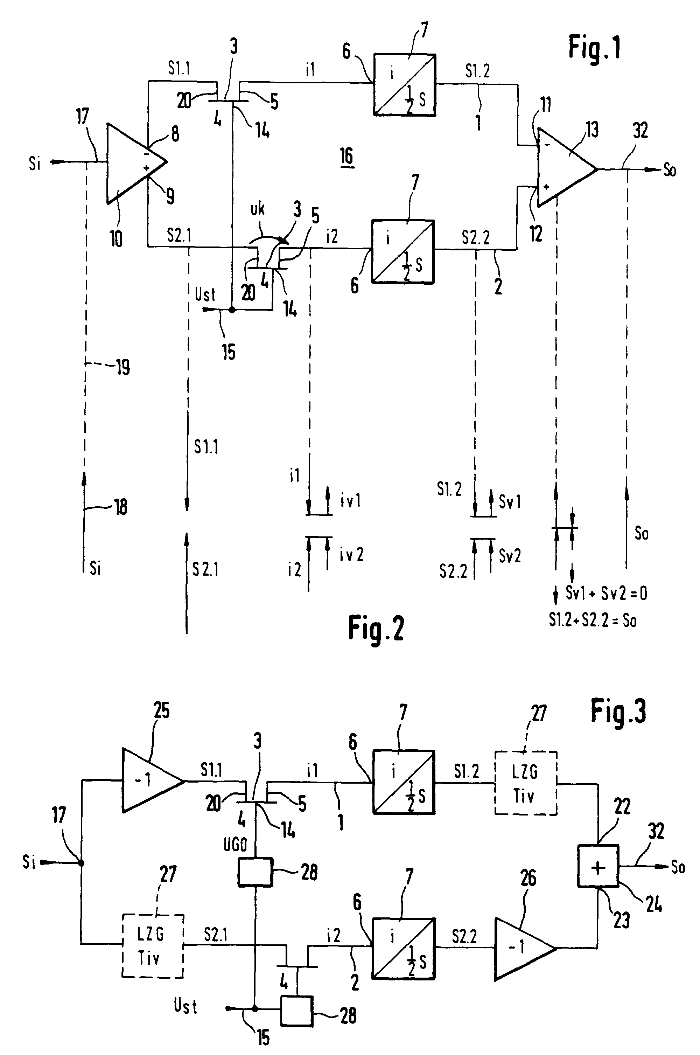

In Fig. 1 ist das Blockschaltbild eines stellbaren elektronischen Widerstandes dargestellt, der parallelle Signalwege 1 und 2, die beide schaltungsmäßig identisch aufgebaut sind, enthält. In jeden Signalweg ist ein Ladungsträgerkanal 3 eines Halbleiterbauelementes 4, zum Beispiel eine Drain-Source-Strecke eines Feldeffekttransistors geschaltet.

Den Ausgangselektroden 5 der Ladungsträgerkanäle 3 ist jeweils ein niederohmiger Eingang 6 eines Strom-Spannungswandlers 7 nachgeschaltet. Eingangsseitig sind die beiden Signalwege 1 und 2 an die Gegentaktausgänge 8 und 9 eines Verstärkers 10 angeschlossen. Ausgangsseitig sind die beiden Signalwege an die Differenzeingänge 11 und 12 eines Differenzverstärkers 13 angeschlossen. Die Steuereingänge 14 zum Einstellen des Widerstandswertes des Ladungsträgerkanals 3 der Halbleiterbauelemente 4 sind parallel geschaltet und bilden gemeinsam einen Stelleingang 15 des stellbaren elektronischen Widerstandes 16. Am Signaleingang 17 des Verstärkers 10 liegt ein zu übertragendes Eingangssignal Si, dessen Augenblickswert des Pegels und dessen Phasenrichtung durch den Pfeil 18 im Pfeilediagramm der Fig. 2 dargestellt ist. Dieses Diagramm zeigt schematisch den Pegel und die Phase des Eingangssignales Si während der Übertragung auf den Signalwegen 1 und 2 an den durch gestrichelte Linien 19 gekennzeichneten Stellen.

Im dargestellten Ausführungsbeispiel überträgt der Verstärker 10 das invertierte Eingangssignal an den Gegentaktausgang 8 und das nichtinvertierte Eingangssignal an den Gegentaktausgang 9 jeweils mit einer Verstärkung = 1. Die Gegentaktausgänge 8 und 9 enthalten damit die gegenphasigen Signalspannungen S1.1 bzw. S2.1. Die Ausgangswiderstände der Gegentaktausgänge 8 und 9 sind so niedrig, daß sie die eingestellten Kanalwiderstände Rk der Ladungsträgerkanäle 3 in den Signalwegen 1 und 2 nicht beeinflussen.

Eine Stellspannung Ust am Stelleingang 15 des stellbaren elektronischen Widerstandes 16 steuert in den Ladungsträgerkanälen 3 jeweils einen entsprechenden Kanalwiderstand Rk, der außerdem noch vom Augenblickswert der sich über der Eingangselektrode 20 und der Ausgangselektrode 5 des Ladungsträgerkanals einstellenden Kanalspannung uk abhängt.
Der Kanalwiderstand Rk ist somit von der Stellspannung Ust und dem Augenblickswert der Kanalspannung uk abhängig. Dieser Kanalwiderstand Rk, dessen Funktion Rk = f(Ust, uk) im dargestellten Ausführungsbeispiel nicht näher dargestellt ist, erzeugt einen entsprechenden Signalstrom i1 bzw. i2 aus der Signalspannungen S1.1 bzw. S2.1.

Infolge der Abhängigkeit des Kanalwiderstandes Rk vom Augenblickswert der Kanalspannung uk ist dem Signalstrom i1 bzw. i2 jeweils ein die Übertragung verzerrender Strom iv1 bzw. iv2 überlagert. Der niederohmige Eingang 6 des Strom-Spannungswandlers 7, der der Ausgangselektrode 5 des Ladungsträgerkanals 3 nachgeschaltet ist, bewirkt, daß die Signalspannung an der Ausgangselektrode 5 sehr gering und damit gegenüber der Stellspannung Ust an der Steuerelektrode 14 vernachlässigbar klein ist.

Der Strom-Spannungswandler 7 wandelt die Signalströme i1 bzw. i2 in ein dem Eingangssignal Si entsprechendes Signal S1.2 bzw. S2.2 und die verzerrenden Ströme iv1 bzw. iv2 in Störspannungen Sv1 bzw. Sv2 proportional um.
Die Störspannungen Sv1 und Sv2 haben in beiden Signalwegen 1 und 2 die gleiche Phase, so daß sie sich bei der Differenzbildung im Differenzverstärker 13 aufheben, während die gegenphasig übertragenen Signale S1.2 und S2.2 im Differenzverstärker 13 addiert werden. Auf diese Weise überträgt der stellbare elektronische Widerstand 16 ein unverzerrtes Ausgangssignal So, das dem Eingangssignal Si entspricht und dessen Pegel von der Größe der Stellspannung Ust am Stelleingang 15 abhängig ist.

Die Fig. 3 zeigt ein weiteres Ausführungsbeispiel. Bei diesem stellbaren elektronischen Widerstandes sind die zwei Signalwege 1 und 2 ausgangsseitig additiv über die Signaleingänge 22 und 23 einer Additionsschaltung 24 zusammengeführt.

Die beiden Signalwege 1 und 2 enthalten ebenfalls je einen Ladungsträgerkanal 3 und je einen Strom-Spannungswandler 7. Der Kanalwiderstand Rk des Ladungsträgerkanals 3 wird durch eine gemeinsame Stellspannung Ust an den beiden Steuerelektroden 14 der beiden Halbleiterbauelemente 4 in der gleichen Weise wie bei dem in Fig. 1 dargestellten Ausführungsbeispiel eingestellt.

Bei dem in Fig. 3 dargestellten Ausführungsbeispiel sind den Steuerelektroden 14 der Halbleiterbauelemente 4 je eine Anpaßschaltung 28 vorgeschaltet, mit der der Kanalwiderstand Rk bei einer bestimmten Stellspannung Ust0 auf einen bestimmten Widerstand Rk0 eingestekllt wird. Dies ist im Diagramm der Fig. 4 näher dargestellt. Dort ist die Abhängigkeit des Kanalwiderstandes Rk des Ladungsträgerkanals 3 und der Verlauf des diesen Ladungsträgerkanal durchfließenden Strom Ik von der Stellspannung Ust der Steuerstrecke (Gate-Source) der Halbleiterbauelemente 4 dargestellt. Auf der Stellspannungsachse Ust sind zwei Grenzwerte UG1 und UG2 dargestellt, zwischen denen die Stellspannung Ust an der Steuerelektrode 14 liegen kann.

Die Strom-Spannungswandler 7 sind so eingestellt, daß sie bei dem Grenzwert UG1 der Stellspannung für den kleinsten Kanalwiderstand des Ladungsträgerkanales an ihrem Ausgang einen Signalpegel erzeugen, der gleich der Hälfte des Pegels des Eingangssignales Si ist. Bei einer Stellspannung Ust0 stellt die Anpaßschaltung 28 einen Kanalwiderstand Rk0, bei dem der Kanalstrom Ik den halben Wert des maximal einstellbaren Kanalstromes Ik1 einnimmt und bei dem der Strom-Spannungswandler 7 einen Ausgangspegel S.2 erzeugt, der gleich 1/4 des Eingangspegels Ui des elektronischen Widerstandes ist. Die Anpaßschaltung 28 erzeugt dann bei dem Stellsignalpegel Ust0 ein Steuersignal UG0.

Der in Fig. 3 dargestellte steuerbare elektronische Widerstand enthält als Mittel zur eingangsseitigen Phaseninversion einen Phaseninverter 25 vor der Eingangselektrode 20 des in den Signalweg 1 geschalteten Ladungsträgerkanales 3 und einen Phaseninverter 26, der dem im anderen Signalweg angeordneten Strom-Spannungswandler 7 nachgeschaltet ist. Durch diese Art der Anordnung der Phaseninverter 25 und 26 in den Signalwegen 1 und 2 des stellbaren elektronischen Widerstandes werden auf die Addition in der Additionsschaltung 24 eventuell störenden Phasenfehler der Phaseninverter 25 und 26 ausgeglichen. Die von den in die Signalleitungen eingeschalteten Phaseninvertern verursachten Laufzeitverzögerungen Tiv können dazu führen, daß durch die Addition in der Signaladditionsschaltung 24 am Ausgang des stellbaren elektronischen Widerstandes nur eine unvollkommene Kompensation der Störsignale erfolgt. Deshalb wird jeweils an die dem Einschaltort des Phaseninverters entsprechende Stelle des anderen Signalweges ein Laufzeitglied 27 eingeschaltet, das die gleiche Laufzeitverzögerung Tiv wie der gegenüberliegende Phaseninverter 25 bzw. 26 enthält.

In den Ausführungsbeispielen einander entsprechende Signale sind mit den gleichen Bezugszeichen bezeichnet. Die mit dem stellbaren elektronischen Widerstand übertragenen Signale Si sind z. B. Signalspannungen.

Die in den Figuren 1 bzw. 3 beschriebenen stellbaren elektronischen Widerstände können auch als elektronische Signalschalter verwendet werden. Dazu wird anstelle einer kontinuierlich einstellbaren Stellspannung Ust eine Schaltspannung mit den Schaltpegeln UG1 bzw. UG2 direkt oder über die Anpaßschaltungen 28 an den Stelleingang 15 gelegt. Der erste Schaltpegel UG1 wird zum Beispiel, wenn der Ladungsträgerkanal von der Steuerstrecke eines bipolaren Feldeffektransistors gebildet wird, so eingestellt, daß diese gerade vollständig gesperrt ist. Auf diese Weise wird erreicht , daß das Eingangssignal Si ohne große Pegelverlust an den Signalausgang 32 übertragen wird, die Stellspannungsquelle nicht belastet wird und der Ladungsträgerkanal nicht durch einen Stellstrom zusätzlich beeinflußt wird. Der zweite Schaltpegel UG2 am Stelleingang 15 wird so gewählt, daß er gerade ausreicht, um die Ladungsträgerkanäle 3 vollständig zu sperren. Beim Umschalten vom ersten Schaltpegel UG1 auf den zweiten Schaltpegel UG2 folgt das übertragene Eingangssignal Si der Schaltflanke innerhalb einer kleinen Zeitspanne, nämlich der Schaltzeit des Schaltvorganges.

Dadurch wird Schaltknacken infolge abgerissener Signalübertragung weitgehend verhindert. Außerdem verhindert ein derartiger Signalschalter bei einem langsamen Schaltvorgang, daß Störsignale auf der Schaltflanke des Schaltsignales eine Art Prellen des Signalschalters hervorrufen, das sich in einem Hin- und Herschalten des Signalschalters im Takt der Rauschstörung auf der Schaltflanke zeigen würde und das zu übertragende Signal erheblich stören würde.

In Fig. 5 ist ein Blockschaltbild eines Signalüberblendschalters mit zwei stellbaren elektronischen Widerständen 16.1 und 16.2 dargestellt, die ausgangsseitig additiv über die Signaleingänge 33 und 34 einer Addierschaltung 35 verbunden sind. Die beiden stellbaren elektronischen Widerstände 16.1 und 16.2 sind identisch und entsprechen im wesentlichen dem in Fig. 1 dargestellten Ausführungsbeispiel. Übereinstimmende Elemente sind mit den gleichen Bezugszeichen bezeichnet. An die Signaleingänge 17 der beiden stellbaren elektronischen Widerstände ist je ein zu übertragendes Signal Si1 und Si2 angelegt. Zum Steuern und Schalten der beiden stellbaren elektronischen Widerstände 16.1 und 16.2 des Signalüberblendschalters sind die Stelleingänge 15.1 und 15.2 je an einen Ausgang 36.1 und 36.2 einer Stellsignalschaltung 37 angeschlossen. Die Ausgänge 36.1 und 36.2 liefern die Stellsignale Ust1 und Ust2 zum Einstellen der erforderlichen Kanalwiderstände der Ladungsträgerkanäle 3.

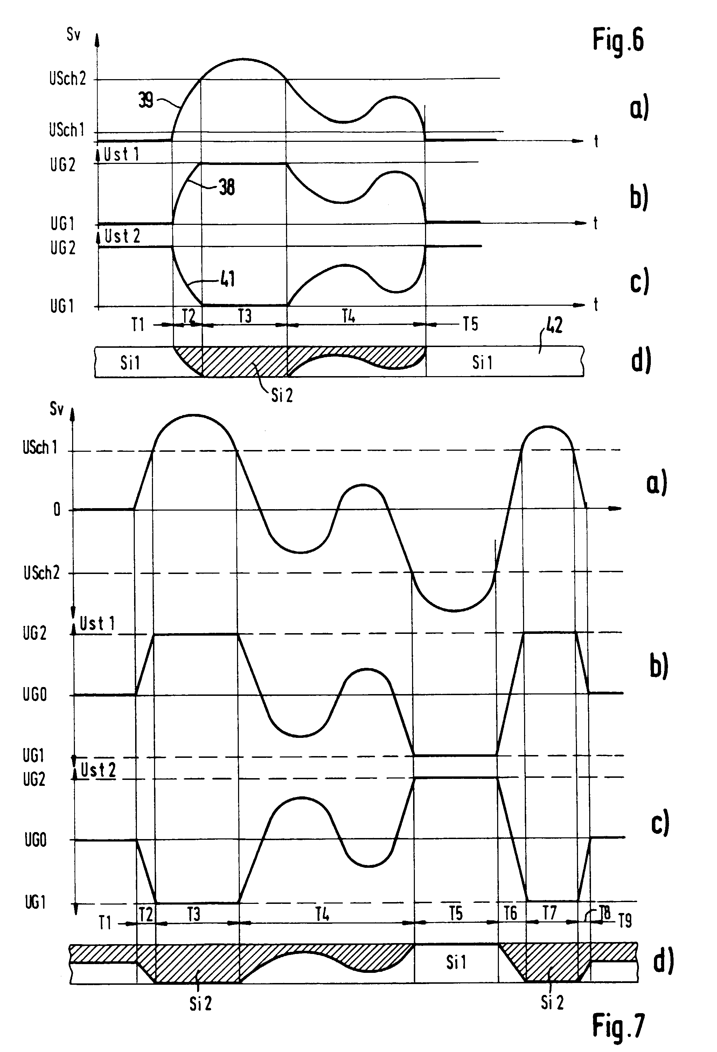

Der Verlauf der Stellsignale Ust1 und Ust2 ist in den Diagrammen b) bzw. c) der Fig.6 dargestellt. Darüber hinaus ist im Diagramm a) der Verlauf 39 des am Eingang 40 der Stellsignalschaltung 37 liegenden Verstellsignales Sv dargestellt.
Die Stellsignalschaltung 37 so beschaffen, daß das am ersten Ausgang 36.1 liegende Stellsignal Ust1 sich dem Verlauf 39 des Verstellsignales Sv folgend von einem ersten Signalgrenzwert UG1 zu einen zweiten Signalgrenzwert UG2 bewegt und diesen Grenzwert nicht übersteigt.

Gleichzeitig bewegt sich das am zweiten Ausgang 36.2 der Stellsignalschaltung 37 liegende Stellssignal Ust2 dem Verlauf 39 des Verstellsignales Sv invers folgend vom zweiten Signalgrenzwert UG2 weg zum ersten Signalgrenzwert UG1, diesen Signalgrenzwert UG1 nicht unterschreitend. Die Anpaßschaltung begrenzt mit den beiden Signalgrenzwerte UG1 und UG2 der Stellsignale Ust1 und Ust2 den Wirkungsbereich des Verstellsignales Sv auf den Bereich zwischen den Schaltspannungen Usch1 und Usch2.

Das Diagramm d) der Fig. 6 zeigt das Ausgangssignal So am Ausgang 43 der Addierschaltung 35. Im Streifen 42 sind die Pegelverläufe der beiden Eingangssignale Si1 (weiß) und Si2 (schraffiert) im Ausgangssignal So zeitabhängig dargestellt. In den Zeitabschnitten T1 und T5 wird nur das erste Eingangssignal Si1 an den Ausgang 43 der Anordnung übertragen. Während des Zeitabschnittes T3 wird nur das zweite Eingangssignal Si2 an den Ausgang 43 übertragen. Im Zeitabschnitt T2 erfolgt ein weiches Überblenden von der Übertragung des ersten Eingangssignales Si1 auf das zweite Eingangssignal Si2. Im Zeitabschnitt T4 werden beide Eingangssignale Si1 und Si2 in unterschiedlicher Signalmischung an den Ausgang 43 der Signalüberblendschaltung übertragen. Mit einer derartigen Anordnung können Umschalt- und Überblendvorgänge zwischen zwei zu übertragenden Signalen an die erforderlichen Umstände angepaßt werden.

In einem anderen vorteilhaften Ausführungsbeispiel ist die Stellsignalschaltung 37 der in Fig. 5 beispielhaft dargestellten Signalüberblendschaltung zusätzlich so ausgebildet, daß sie dann, wenn an ihrem Eingang 40 kein Verstellsignal Sv anliegt, an ihren beiden Ausgängen 36.1 und 36.2 ein Stellsignal erzeugt, das jeweils den gleichen Stellpegel UG0 aufweist. Dieser liegt zwischen dem ersten Grenzwert UG1 und dem zweiten Grenzwert UG2 des Stellsignales Ust und ist im Beispiel so bemessen, daß jeder stellbare elektronische Widerstand 16.1 und 16.2 der Signalüberblendschaltung das Eingangssignal Si1 und Si2 mit dem halben Signalpegel überträgt, so daß am Ausgang 43 der Addierschaltung 35 ein Ausgangssignal So mit jeweils dem gleichen Anteil der beiden Eingangssignale Si1 und Si2 erzeugt wird.

Zur Erläuterung dieses Sachverhaltes zeigt Diagramm a) der Fig. 7 den Verlauf eines Verstellsignales Sv am Eingang 40 der Stellsignalschaltung 37 und in den Diagrammen b) und c) der Fig. 7 der Verlauf der Stellsignale Ust1 und Ust2. Das Band 47 im Diagramm d) der Fig. 7 stellt wiederum die Anteile der Eingangssignale Si1 und Si2 im Ausgangssignal So am Signalausgang 43 der Addierschaltung 35 dar. In den Zeitabschnitten T1 und T9, in denen am Eingang 40 der Stellsignalschaltung 37 kein Verstellsignal Sv liegt, werden die Eingangssignale Si1 und Si2 jeweils zur Hälfte an den Signalausgang 43 der Signalüberblendschaltung übertragen. Während des Zeitabschnittes T2 wird weich auf die Übertragung des zweiten Eingangssignales Si2 umgeschaltet. Im Zeitabschnitt T4 werden die beiden Eingangssignale im wechselnden Verhältnis, dem Verlauf 44 des Verstellsignales folgend an den Signalausgang 43 übertragen und im Zeitabschnitt T5 nur das erste Eingangssignal Si1 an den Signalausgang 43 der Signalüberblendschaltung übertragen. Während des Zeitabschnittes T6 erfolgt eine weiche Umschaltung von der Übertragung des ersten Eingangssignales Si1 auf die alleinige Übertragung des zweiten Eingangssignales Si2 während des Zeitabschnittes T7. Während des Zeitabschnittes T8 erfolgt ein weicher Übergang in den Ruhezustand der Stellsignalschaltung 37, in dem sie die Übertragung der beiden Eingangssignale Si1 und Si2 zu gleichen Teilen bewirkt.

## Patentansprüche

1. Stellbarer elektronischer Widerstand mit
- zwei parallelen Signalwegen (1, 2), die seriell angeordnete, einstellbare Ladungsträgerkanäle (3) von Halbleiterbauelementen (4) enthalten, bei denen der Kanalwiderstand (Rk) an einer Steuerelektrode (14) einstellbar ist, wobei die Steuerelektroden (14) der Halbleiterbauelemente (4) zu einem Stelleingang (15) zusammengeschaltet sind
- einer eingangsseitigen Schaltung (10, 25) zum Erzeugen von zwei gegenphasigen Signalen (S1.1, S2.1) aus einem Eingangssignal (Si) für die Signalwege (1, 2)
- und einer Schaltung (13 oder 22, 26) zum linearen Zusammenführen der gegenphasigen Ausgangssignale (S1.2, S2.2) der parallelen Signalwege (1, 2),
**gekennzeichnet dadurch**, daß jeder Signalweg (1, 2) nur einen einstellbaren Ladungsträgerkanal (3) enthält und daß der Ausgangselektrode (5) jedes Ladungsträgerkanals eine Stufe (7) mit einem niederohmigen Eingang (6) folgt, der gegenüber dem niedrigsten einstellbaren Widerstand des Ladungsträgerkanals so gering ist, daß die Signalspannung an der Ausgangselektrode (5) sehr gering und damit gegenüber der Stellspannung Ust an der Steuerelektrode (14) vernachlässigbar klein ist.

2. Stellbarer elektronischer Widerstand nach Anspruch 1, dadurch gekennzeichnet, daß die Ladungsträgerkanäle (3) die Drain-Source-Strecke eines Feldeffekttransistors sind.

3. Stellbarer elektronische Widerstand nach Anspruch 1, dadurch gekennzeichnet, daß die den Ausgangselektroden (5) der Ladungsträgerkanäle (3) nachgeschalteten Stufen Strom-Spannungswandler (7) sind.

4. Stellbarer elektronischer Widerstand nach Anspruch 1, dadurch gekennzeichnet, daß die Schaltung zum Erzeugen von zwei gegenphasigen Signalen aus dem Eingangssignal (Si) ein im ersten Signalweg (1) vor der Eingangselektrode (20) des Ladungsträgerkanals (3) angeordneter Phaseninverter (25) ist, daß die Schaltung zum linearen Zusammengeführen der Ausgangssignale der parallelen Signalwege (1, 2) ein Addierer (22) ist und daß vor dem im zweiten Signalweg (2) Addierer (22) ein Phaseninverter (26) angeordnet ist.

5. Signalüberblendschaltung mit zwei elektronisch stellbaren Widerständen nach Anspruch 1, zum Übertragen zweier Eingangssignale (Si1, Si2), die je an einem Signaleingang (17) eines elektronischen Widerstandes (16.1, 16.2) liegen,
**gekennzeichnet**
- durch einen weiteren Addierer (35) dessen Eingänge (33, 34) an den Ausgängen (32) der beiden elektronisch stellbaren Widerstände (16.1, 16.2) angeschlossen sind,
- und durch eine Stellsignalschaltung (37) mit zwei Ausgängen (36.1, 36.2), die von einem Verstellsignal (Sv) für die Stelleingänge (15) der beiden stellbaren elektronischen Widerstände je ein Stellsignal (Ust1, Ust2) bereitstellt, wobei das erste Stellsignal (Ust1) dem Verstellsignal (Sv) direkt folgt, so daß die in den Signalweg (1, 2) eines ersten elektronisch stellbaren Widerstandes liegenden Ladungsträgerkanäle maximal leitend werden und gleichzeitig das zweite Stellsignal (Ust2) dem Verstellsignales (Sv) invers folgt, so daß die in den Signalwegen (1, 2) des anderen stellbaren elektronischen Widerstandes liegenden Ladungsträgerkanäle gesperrt werden.

6. Signalüberblendschaltung nach Anspruch 5, dadurch gekennzeichnet, daß die Stellsignale (Ust1, Ust2) bei einem Eingangssignal (Ust) mit dem Pegelwert Null den gleichen Pegel haben.

## Claims

1. Variable electronic resistor comprising
- two parallel signal paths (1, 2) containing serially disposed, adjustable charge carrier channels (3) of semiconductor components (4) whose channel resistance (Rk) is adjustable at a gate electrode (14), the gate electrodes (14) of the semiconductor components (4) being connected together to form a setting input (15),
- an input-side circuit (10, 25) for generating two antiphase signals (S1.1, S2.1) from one input signal (Si) for the signal paths (1, 2),
- and a circuit (13 or 22, 26) for bringing together linearly the antiphase output signals (S1.2, S2.2) of the parallel signals path (1, 2),
characterized in that each signal path (1, 2) contains only one adjustable charge carrier channel (3) and in that the output electrode (5) of each charge carrier channel is followed by a stage (7) having a low-resistance input (6) which is so low compared with the lowest adjustable resistance of the charge carrier channel that the signal voltage at the output electrode (5) is very low and, consequently, is negligibly small compared with the setting voltage Ust at the gate electrode (14).

2. Variable electronic resistor according to Claim 1, characterized in that the charge carrier channels (3) are the drain-source section of a field-effect transistor.

3. Variable electronic resistor according to Claim 1, characterized in that the stages connected downstream of the output electrodes (5) of the charge carrier channels (3) are current/voltage converters (7).

4. Variable electronic resistor according to Claim 1, characterized in that the circuit for generating two antiphase signals from the input signal (Si) is a phase inverter (25) disposed in the first signal path (1) upstream of the input electrode (20) of the charge carrier channel (3), in that the circuit for linearly combining the output signals of the parallel signal paths (1, 2) is an adder (22) and in that a phase inverter (26) is disposed upstream of the adder (22) in the second signal path (2).

5. Signal cross-fading circuit comprising two electronically variable resistors according to Claim 1, for transmitting two input signals (Si1, Si2) which are each present at a signal input (17) of an electronic resistor (16.1, 16.2), characterized
- by a further adder (35) whose inputs (33, 34) are connected to the outputs (32) of the two electronically variable resistors (16.1, 16.2),
- and by a setting signal circuit (37) having two outputs (36.1, 36.2), which each provide one setting signal (Ust1, Ust2) from one re-setting signal (Sv) for the setting inputs (15) of the two variable electronic resistors, the first setting signal (Ust1) directly following the re-setting signal (Sv) so that the charge carrier channels present in the signal path (1, 2) of a first electronically variable resistor acquire maximum conductance and, at the same time, the second setting signal (Ust2) follows the re-setting signal (Sv) inversely so that the charge carrier channels present in the signal paths (1, 2) of the other variable electronic resistor are turned off.

6. Signal cross-fading circuit according to Claim 5, characterized in that the setting signals (Ust1, Ust2) have the same level for an input signal (Ust) having the level value zero.

## Revendications

1. Résistance électronique contrôlable avec
- deux chemins de signal (1, 2) parallèles, qui contiennent des canaux porteurs de charge (3), disposés en série et réglables d'éléments semi-conducteurs (4), sur lesquels la résistance de canal (Rk) est réglable sur une électrode de commande (14), les électrodes de commande (14) des composants semi-conducteurs (4) étant interconnectés à une entrée de réglage (15)
- un circuit (10, 25) côté entrée pour générer deux signaux (S1.1, S2.1) en opposition de phase à partir d'un signal d'entrée (Si) pour les chemins de signal (1, 2)
- et un circuit (13 ou 22, 26) pour la jonction linéaire des signaux d'entrée (S1.1, S2.2) en opposition de phase des chemins de signal (1, 2) parallèles, caractérisée en ce que chaque chemin de signal (1, 2) ne contient qu'un seul canal porteur de charge (3) réglable et en ce que l'électrode de sortie (5) de chaque canal porteur de charge est suivie d'un étage (7) avec une entrée (6) de basse impédance qui est si faible par rapport à la résistance réglable la plus faible du canal porteur de charge que la tension de signal est très faible sur l'électrode de sortie (5) et est donc négligeable par rapport à la tension (Ust) de réglage sur l'électrode de commande (14).

2. Résistance électronique contrôlable selon la revendication 1, caractérisée en ce que les canaux porteurs de charge (3) sont le tronçon drain-source d'un transistor à effet de champ.

3. Résistance électronique contrôlable selon la revendication 1, caractérisée en ce que les étages situés en aval des électrodes de sortie (5) des canaux porteurs de charge (3) sont des transformateurs courant-tension (7).

4. Résistance électronique contrôlable selon la revendication 1, caractérisée en ce que le circuit pour générer deux signaux en opposition de phase à partir du signal d'entrée (Si) est un inverseur de phase (25) disposé dans le premier chemin de signal (1) avant l'électrode d'entrée (20) du canal porteur de charge (3), en ce que le circuit pour la jonction linéaire des signaux de sortie des chemins de signal (1, 2) parallèles est un additionneur (22) et en ce qu'un inverseur de phase (26) est disposé dans le deuxième chemin de signal (2) additionneur (22).

5. Circuit d'enchaînement de signal avec deux résistances contrôlables par électronique selon la revendication 1, pour la transmission de deux signaux d'entrée (Si1, Si2), qui se trouvent chacune sur un signal d'entrée (17) d'une résistance (16.1, 16.2) électronique, caractérisé
- par un autre additionneur (35) dont les entrées (33, 34) sont raccordées aux sorties (32) des deux résistances (16.1, 16.2) contrôlables par électronique,
- et par un circuit de signal de réglage (37) avec deux sorties (36.1, 36.2), qui mettent à disposition chacune un signal de réglage (Ust1, Ust2) à partir d'un signal de commande (Sv) pour les entrées de réglage (15) des deux résistances électroniques contrôlables, le premier signal de réglage (Ust1) suit directement le signal de commande (Sv), de sorte que les canaux porteurs de charge se trouvant dans les chemins de signal (1, 2) d'une première résistance contrôlable par électronique devient conducteur au maximum et qu'en même temps le deuxième signal de réglage (Ust2) suit de façon inversée le signal de commande (Sv), de sorte que les canaux porteurs de charge se trouvant dans les chemins de signal (1, 2) de l'autre résistance électrique contrôlable sont bloqués.

6. Circuit d'enchaînement de signal selon la revendication 5, caractérisé en ce que les signaux de réglage (Ust1, Ust2) ont le même niveau lors d'un signal d'entrée (Ust) avec la valeur de niveau zéro.
